# Europäisches Patentamt

# European Patent Office

# Office européen des brevets

(19)

(11) Veröffentlichungsnummer: **0 148 218**

**B1**

(12) # EUROPÄISCHE PATENTSCHRIFT

(45) Veröffentlichungstag der Patentschrift:
**18.05.88**

(51) Int. Cl.⁴: **H 03 H 7/38**

(21) Anmeldenummer: **84902439.3**

(22) Anmeldetag: **28.06.84**

(86) Internationale Anmeldenummer:
**PCT/CH 84/00107**

(87) Internationale Veröffentlichungsnummer:
**WO 85/00479 (31.01.85 Gazette 85/03)**

(54) **VERFAHREN ZUR ANPASSUNG EINER UEBERTRAGUNGSKETTE FÜR AUDIOSIGNALE.**

(30) Priorität: **30.06.83 CH 3586/83**

(43) Veröffentlichungstag der Anmeldung:
**17.07.85 Patentblatt 85/29**

(45) Bekanntmachung des Hinweises auf die Patenterteilung:
**18.05.88 Patentblatt 88/20**

(84) Benannte Vertragsstaaten:
**AT BE CH DE FR GB LI LU NL SE**

(56) Entgegenhaltungen:
**FR-A-892 348**
**US-A-2 768 355**
**US-A-2 978 542**

**T.E. Shea: "Transmission Networks and Wave Filters", 1929, Chapman & Hall, London (GB), siehe "Chapter I", "Chapter IV"**

(73) Patentinhaber: **SEPS, Daniel, Seestrasse 336, CH-8038 Zürich (CH)**
Patentinhaber: **SUCHY, Petr, Anderlohstrasse 48, D-8520 Erlangen (DE)**

(72) Erfinder: **NEMETH, Rudolf, Hardgutstrasse 28, CH-8048 Zürich (CH)**
Erfinder: **SEPS, Daniel, Seestrasse 336, CH- 8038 Zürich (CH)**
Erfinder: **SUCHY, Petr, Anderlohstrasse 48, D-8520 Erlangen (DE)**

(74) Vertreter: **Feldmann, Clarence Paul, c/o Patentanwaltsbüro FELDMANN AG Postfach Kanalstrasse 17, CH- 8152 Glattbrugg (CH)**

LIBER, STOCKHOLM 1988

## Beschreibung

Die vorliegende Erfindung betrifft ein Verfahren zur Anpassung einer Uebertragungskette bestehend aus einem Sender mit Treiberimpedanz $Z_T$, einem Empfänger mit Abschlussimpedanz $Z_A$ und einem Zwischenglied mit Impedanz Z, die untereinander so angepasst sind, dass gilt $Z_T = Z = Z_A$, wobei die einzelnen Impedanzen $Z_T$, Z, $Z_A$ entsprechend der eventuellen Frequenzabhängigkeit angepasst sind.

Die Uebertragungskette soll hier im weitesten Sinne aufgefasst werden, bestehend aus einem Treiberglied (beziehungsweise Senderglied), einem Zwischenglied und einem Abschlussglied (beziehungsweise Empfängerglied). Hierbei umfasst das Zwischenglied mindestens ein Kabel sowie gegebenenfalls einen Filter und/oder Regler.

Es ist aus der Fachliteratur bekannt, dass der Einfluss kurzer Kabel (kurz bezüglich der Wellenlänge des Signals) bezüglich Dämpfung und Phasendrehung bei Audiofrequenzen f < 20'000 Hz sehr gering ist.

So liegt beispielsweise die Dämpfung üblicher Kabel bei einer Frequenz von 1'000 Hz um $10^{-4}$ dB/m, während die Phasendrehung kleiner als 0,04°/m ist.

Es ist daher nicht verwunderlich, dass in der Audiotechnik der genauen Impedanz-Anpassung der einzelnen Glieder einer Uebertragungskette wenig bis keine Bedeutung zugemessen wurde.

In der HF-Technik werden Kabel ohm'sch abgeschlossen, entsprechend dem Wellenwiderstand des Kabels. Bekanntlich ist der Wellenwiderstand eines Kabels von der Frequenz abhängig.

Bei tiefen Frequenz mit $R >> \omega \cdot L$ gilt: $|z| = \sqrt[4]{\frac{R^2}{G^2 + \omega^2 C^2}}$

während

bei hohen Frequenzen mit $R << \omega \cdot L$ gilt: $|z| = \sqrt{\frac{L}{C}}$, worin R der Längswiderstand, G der Querleitwert, L die Längsinduktivität und C die Querkapazität jeweils pro Meter Kabellänge sind.

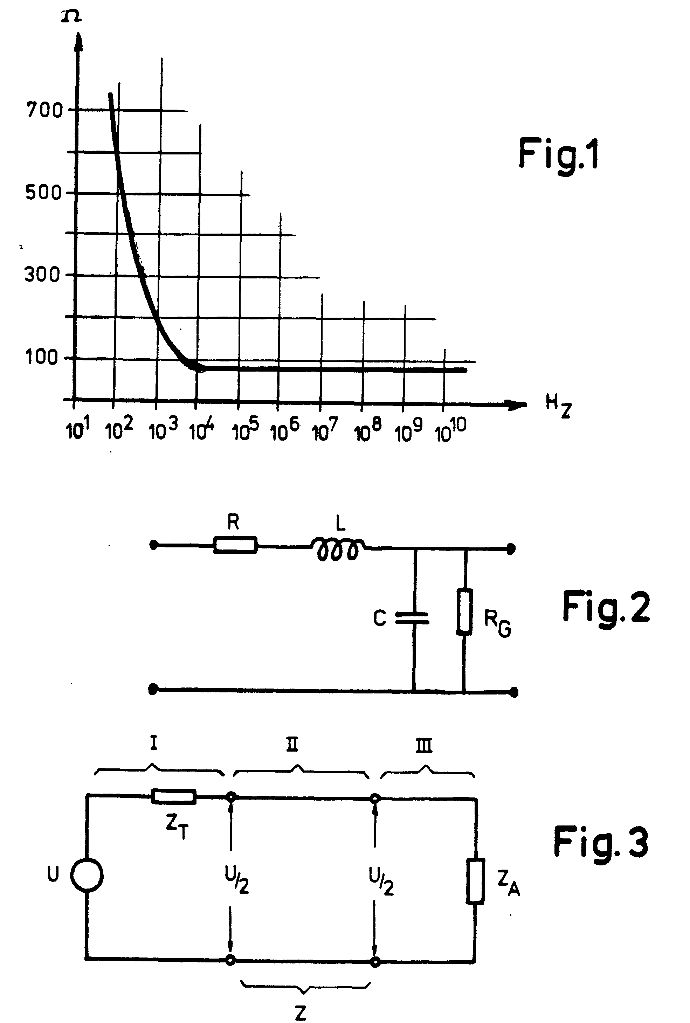

Aus diesen Formeln folgt die in der Figur 1 dargestellte (typische) Kurve.

Aus der Kurve ist ersichtlich, dass für hohe Frequenzen mit guter Annäherung ein einfacher ohm'scher Widerstand zur Anpassung genügt.

Diesen Erkenntnissen zum Trotz hat der Anmelder grosse Serien von Versuchen durchgeführt, bei denen er die Impedanz der einzelnen Glieder der Uebertragungskette abgeglichen hat und auf diese Weise, die sich gestellte Aufgabe, die Verbesserung der Tonqualität von Audioanlagen gelöst.

In erster Annäherung wurde die Aufgabe dadurch gelöst, dass die Ausgangsimpedanz des Sendegliedes und die Abschlussimpedanz beim Empfängerglied dem konstanten Teil der Gesamtimpedanz des Zwischengliedes angepasst worden ist.

Eine weitere Verbesserung der Tonqualität einer Audioanlage kann dadurch erreicht werden, dass die Ausgangsimpedanz des Treibergliedes und die Abschlussimpedanz beim Empfängerglied mit der mindestens angenäherten Charakteristik des Wellenwiderstandes frequenzabhängig abgeglichen ist.

Ist das Zwischenglied ein Kabel, so ist es wünschenswert, wenn dieses frequenzunabhängig wäre. Nun gilt jedoch gemäss der Grundgleichung der gedämpften Leitung

$$\bar{z} = \sqrt{\frac{R + j\omega L}{G + j\omega C}}. \quad (1)$$

Ferner gilt:

$G = \frac{1}{R_G}$ ($R_G$ = Isolaitionswiderstand pro Meter Kabellänge)

Aus (1) folgt somit:

$$\bar{z} = \sqrt{\frac{L}{C}} \cdot \frac{\frac{R}{j\omega L} + 1}{\frac{G}{j\omega C} + 1} \quad (2)$$

Aus (2) erkennt man, dass unter der Bedingung, dass $\frac{R}{G}$ sich verhält wie $\frac{L}{C}$, der Wellenwiderstand frequenzunabhängig wird. Es gilt somit:

$$\frac{R}{G} = \frac{L}{C} \quad (3)$$

Die theoretische Ueberlegung, bei niedrigen Frequenzen auf den Einsatz angepasster Leitungen verzichten zu können, beruht auf der Tatsache, dass sich zwei nahe beeinanderliegende Reflexionsstellen bezüglich der erzeugten Reflexionen kompensieren. Dieser Ueberlegungen liegt aber die Annahme gleicher Impedanz von Quelle und Verbraucher zugrunde. Für den Reflexionsfaktor an den Berührungsstellen von Leitungen unterschiedlicher Impedanz gilt:

Reflexionsfaktor $\Gamma = \frac{Z_0 - Z_0}{Z_0 + Z_0}$

$Z_Q$ = Quellenimpedanz

$Z_0$ = Leitungsimpedanz

Bei der Verbindung einer Quelle mit einem Verbraucher mittels einer Leitung ergibt sich:

$\Gamma_1 = \frac{Z_0 - Z_Q}{Z_0 + Z_Q}$ ; $\Gamma_2 = \frac{Z_0 - Z_V}{Z_0 + Z_V}$ ; fals $Z_Q = Z_V$, so ergigt sich $\Gamma_1 = \Gamma_2$

$Z_V$ = Verbraucherimpedanz

Hierbei stellt $\Gamma_1$ den Reflektionsfaktor an der Schnittstelle zwischen Quelle und Leitung $\Gamma_2$ an der Schnittstelle zwischen Leitung und Verbraucher.

Man sieht, dass sich bei kurzer Leitung $\Gamma_1$ und $\Gamma_2$ aufheben. In der Audio-Technik liegen die Verhältnisse anders. Man arbeitet, z. B. bei Verstärker -Lautsprecher-Verbindung, um möglichst preisgünstig Leistung erzeugen zu können, mit niedrigen Quellenimpedanzen. Die Verbraucher-Impedanz (Lautsprecher) liegt hingegen bei ca. 8 ohm (typisch 4 bis 40 ohm). Die Reflexionsfaktoren der Hörstellen am Eingang und Ausgang der Kabel heben sich somit keineswegs auf. Reflexionen des Audiosignals können sogar wegen der geringen Dämpfung der Lautsprecher-Kabel mehrmals entstehen, dass heisst, die reflektierten Signale laufen zwischen den Kabelenden hin und her.

In früheren Zeiten, als noch Röhrenverstärker üblich waren, deren Ausgangsleistung begrenzt war, musste auf diese Anpassung jedoch regelmässig nach den gegebenen Möglichkeiten geachtet werden. Es sei nur daran erinnert, dass die Ausgangsimpedanz einer Endstufenpenthode in der Grössenordnung von 5 - 10 kΩ liegt und man einen Lautsprecher mit der Impedanz von 5 Ω daran nicht direkt anschliessen konnte. Man verwendete einen Ausgangsübertrager, der die notwendige Anpassung bewerkstelligte. Erinnert sei auch an die sogenannten eisenlosen Endstufen, bei denen der Ausgangsanpassungsübertrager eingespart werden konnte. Man hatte eine Röhren-Audioendstufe entwickelt, deren Ausgangsimpedanz nur noch etwa 800 Ω betrug und schloss daran spezielle Lautsprecher mit einer Impedanz von ebenfalls 800 Ω an.

Es ist aber gesagt worden, dass die Anpassung von Verstärkerausgang und dem Verbraucher nach den gegebenen Möglichkeiten durchgeführt wurde. Damit soll gesagt werden, dass die Impedanz eines Lautsprechers in Abhängigkeit von der Frequenz keinesfalls konstant ist, ebenso nicht die Ausgangsimpedanz eines Audioverstärkers, insbesondere bei Zwischenschaltung eines Anpassungsübertragers, so dass es in bestimmten Frequenzbereichen durchaus zu Fehlanpassungen kommt. Diese Fehlanpassungen wurden nach dem, was der Stand der Technik zeigt, bislang toleriert. Aus diesem Grunde könnte es daher tatsächlich einen Sinn haben, das Zuleitungskabel zum Verbraucher (Lautsprecher) - wiederum nach den gegebenen Möglichkeiten - an die Quellen- und Lastimpedanz anzupassen, weil sich in den Frequenzbereichen, in denen die angestrebte Anpassung zwischen Verstärkerausgang und Verbraucher nicht erzielt wird, die Reflexionen an kurzen Kabelstücken nicht aufheben.

Es ist daher die Aufgabe der vorliegenden Erfindung, ein Verfahren zur Anpassung einer Uebertragungskette einer Audioanlage unter Berücksichtigung obiger Aspekte hörbar zu verbessern.

Dieses Ziel wird durch das Verfahren gemäss Patentanspruch 1 erzielt.

Zur Erläuterung der Erfindung ist in der Zeichnung

in Figur 1 eine Grafik dargestellt, die den (typischen) Wellenwiderstand eines Leiters in Abhängigkeit der Frequenz zeigt;

in Figur 2 ist ein Ersatzschaltbild einer kurzen Leitung, und

in Figur 3 ein Schaltbild einer erfindungsgemäss angepassten Uebertragungskette.

Wie bereits eingangs erwähnt, weist der Wellenwiderstand eines Leiters eine Charakteristik, die in Abhängigkeit seiner physikalischen Daten spezifisch ist. In der Grafik ist eine typische Charakteristik dargestellt. Es ist deutlich ersichtlich, dass der Wellenwiderstand ab einer gewissen Frequenz sich konstant verhält.

Aus Versuchen folgt, dass bei geeigneter Wahl des Leiters in erster Näherung eine Audio-Uebertragungskette ohm'sch abgeschlossen werden kann, wobei $Z_T = Z = Z_A$ gilt.

Prinzipiell lässt sich eine kurze Leitung durch das Ersatzschaltbild nach Figur 2 darstellen. Aus dem Ersatzschaltbild ist ersichtlich, dass die Widerstände mit denen angetrieben und abgeschlossen wird, einen wesentlichen Einfluss hat.

Wie in Figur 3 schematisch dargestellt, wird das Treiberglied I (Treiberimpedanz $Z_T$) mit der Impedanz $Z_A$ abgeschlossen, die genau der Impedanz Z des Zwischengliedes II, bzw. des Wellenwiderstandes entspricht, $Z_T = Z = Z_A$

Unter Einhaltung der Formel $Z_T = Z = Z_A$ ist es für die Anpassung sinnvoll immer vom gegebenen, festen Wert einer der drei Impedanzen auszugehen und die beiden anderen Impedanzen diesem vorgegebenen Wert anzupassen.

Die besten Resultate wurden erzielt, wenn die Impedanzen $Z_T$, Z, $Z_A$ auch in den Charakteristiken sich entsprechen. Als Zwischenglieder können zusätzlich zum Kabel, Filter oder Regler gelten.

Wie eingangs nachgewiesen wurde, lässt sich das Kabel auch so wählen, dass die Frequenzabhängigkeit annähernd verschwindet. Eine Lösung wurde darin gefunden, dass man das Isolationsmaterial des Kabels entsprechend verändert, im konkreten Fall, schlechter isolierend herstellt. Gute Messresultate ergaben Kabel mit einem Wellenwiderstand von annähernd 8 Ohm. Für kurze Leiter, wie sie in Uebertragungsketten für Audiosignale, beispielsweise zwischen Abspielgeräten, wie Plattenspieler und Cassettenrecorder und Verstärker oder Zwischenverstärker vorkommen, spielt der dabei in Kauf zu nehmende Leistungsabfall von ca. 1,5 dB pro 100 m Kabel keine Rolle.

Obwohl die Aenderung der Widerstandwerte des Kabels durch Einfügung von Widerständen in regelmässigen Abständen möglich ist, scheint es sinnvoller, den Querleitwert beziehungsweise den Isolationswiderstand so zu ändern, dass die Bedingung $\frac{R}{G} = \frac{L}{C}$ erfüllt werden kann. Dies kann durch die Wahl des Isolationsmaterials erreicht werden.

Aber auch durch die Mischung bekannter Isolationsmaterialien mit leitender Thermoplaste und/oder der Beimengung von leitenden Materialien in das Isolationsmaterial sind geeignet den Querleitwert entsprechend zu ändern.

Besonders vorteilhaft ist es, wenn man ein vorgewähltes Kabel nimmt und in dessen Anfang- und Endstecker die angepassten Treiber bzw. Abschlussimpedanz unterbringt. Aber auch diverse Zwischenglieder lassen sich in Stecker des Kabels unterbringen, wie Regler der Filter.

**Patentansprüche**

1. Verfahren zur Anpassung einer Uebertragungskette bestehend aus einem Sender mit Treiberimpedanz $Z_T$, einem Empfänger mit Abschlussimpedanz $Z_A$ und einem Zwischenglied mit Impedanz Z, die untereinander so angepasst sind, dass gilt $Z_T = Z = Z_A$, wobei die einzelnen Impedanzen $Z_T$, Z, $Z_A$ entsprechend der eventuellen Frequenzabhängigkeit angepasst sind, dadurch gekennzeichnet, dass bei Baueinheiten einer Audioanlage das Zwischenglied mindestens ein Kabel mit einem Wellenwiderstand umfasst, welcher mittels angepasstem Querleitwert G, die vorgenannte Bedingung erfüllt und wobei gilt, dass $\frac{R}{G} = \frac{L}{C}$ ist, mit

R = Längswiderstand pro Meter Kabellänge
G = Querleitwert pro Meter Kabellänge
L = Längsinduktivität pro Meter Kabellänge
C = Querkapazität pro Meter Kabellänge.

2. Verfahren nach Anspruch 1, dadurch gekennzeichnet, dass das Zwischenglied zusätzlich mit einem Filter und/ oder Regler versehen wird.

3. Verfahren nach Anspruch 1, dadurch gekennzeichnet, dass der Querleitwert G des Kabels durch die Wahl des Isolationsmaterials passend geändert wird.

4. Verfahren nach Anspruch 1, dadurch gekennzeichnet, dass der Querleitwert G des Kabels durch Zufügung von leitendem Material in der Isolation entsprechend geändert wird.

5. Verfahren nach Anspruch 1, dadurch gekennzeichnet, dass ein vorgewähltes Kabel mit Steckern versehen wird, in denen die angepasste Treiberimpedanz ($Z_T$) und Abschlussimpedanz ($Z_A$) untergebracht sind.

6. Verfahren nach Anspruch 2 und 5, dadurch gekennzeichnet, dass am Kabel weitere Zwischenglieder angeschlossen werden, die ebenfalls in den Steckern untergebracht sind.

**Claims**

1. Method for matching a transmission chain comprising a transmitter with driving impedance $Z_T$, a receiver with load impedance $Z_A$ and a link with impedance Z, which are so matched with respect to one another that $Z_T = Z = Z_A$, the individual impedances $Z_T$, Z, $Z_A$ being matched in accordance with the possible frequency dependence, characterized in that in the case of components of an audio installation the link comprises at least one cable with a characteristic impedance which, by means of matched shunt conductance G fulfils the aforementioned condition and in which $\frac{R}{G} = \frac{L}{C}$ with

R = series resistance per metre of cable length
G = shunt conductance per metre of cable length
L = series inductance per metre of cable length
C = shunt capacitance per metre of cable length.

2. Method according to claim 1, characterized in that the link is additionally provided with a filter and/or regulator.

3. Method according to claim 1, characterized in that the shunt conductance G of the cable is modified in matching manner by the choice of insulating material.

4. Method according to claim 1, characterized in that the shunt conductance G of the cable is correspondingly modified by adding conductive material to the insulation.

5. Method according to claim 1, characterized in that a preselected cable is provided by plugs containing the matched driving impedance ($Z_T$) and load impedance ($Z_A$).

6. Method according to claims 2 and 5, characterized in that to the cable are connected further links, which are also placed in the plugs.

**Revendications**

1. Procédé d'adaptation d'une chaîne de transmission se composant d'un émetteur ayant une impédance d'entrée $Z_T$, d'un récepteur ayant une impédance de sortie $Z_A$ et d'un élément intermédiaire ayant une impédance Z, adaptées entre elles de manière telle que l'on ait $Z_T = Z = Z_A$, les différentes impédances $Z_T$, Z, $Z_A$ étant adaptées selon leur éventuelle dépendance de la fréquence, caractérisé en ce que, dans le cas d'éléments d'une installation audio, l'élément intermédiaire comprend au moins un câble avec une résistance aux ondes qui, à l'aide d'une valeur de conductivité transversale adaptée G, répond à la condition susdite et où $\frac{R}{G} = \frac{L}{C}$,

R étant la résistance longitudinale par mètre de longueur de câble
G étant la valeur de conductivité transversale par mètre de longueur du câble
L étant l'inductivité longitudinale per mètre de longueur du câble
C étant la capacité transversale par mètre de longueur du câble

2. Procédé selon la revendication 1, caractérisé par le fait que l'élément intermédiaire est en outre équipé d'un filtre et/ou d'un régulateur.

3. Procédé selon la revendication 1, caractérisé par le fait que la valeur de la conductivité transversale G du câble est modifiée de manière adéquate grâce au choix du matériau isolant.

4. Procédé selon la revendication 1, caractérisé par le fait que la valeur de la conductivité transversale G du câble est modifiée de manière correspondante moyennant l'addition de matériau conducteur dans l'isolation.

5. Procédé selon la revendication 1, caractérisé par le fait qu'un câble choisi est muni de fiches pourvues de l'impédance d'entrée ($Z_T$) et de l'impédance de sortie ($Z_A$).

6. Procédé selon les revendications 2 et 5, caractérisé par le fait que le câble est relié avec d'autres éléments intermédiaires qui sont également logés dans les fiches.

0 148 218

Fig.1

Fig.2

Fig.3